(19) Europäisches Patentamt
European Patent Office
Office européen des brevets

(11) **EP 4 600 681 A1**

(12) **EUROPEAN PATENT APPLICATION**
published in accordance with Art. 153(4) EPC

(43) Date of publication:
**13.08.2025 Bulletin 2025/33**

(21) Application number: **23907301.8**

(22) Date of filing: **19.09.2023**

(51) International Patent Classification (IPC):
$G01R\ 31/52^{(2020.01)}$    $G01R\ 31/392^{(2019.01)}$
$G01R\ 31/396^{(2019.01)}$    $G01R\ 31/385^{(2019.01)}$
$G01R\ 31/3842^{(2019.01)}$    $G01R\ 19/30^{(2006.01)}$

(52) Cooperative Patent Classification (CPC):
**G01R 19/30; G01R 31/3842; G01R 31/385;
G01R 31/392; G01R 31/396; G01R 31/52**

(86) International application number:
**PCT/KR2023/014168**

(87) International publication number:
**WO 2024/136015 (27.06.2024 Gazette 2024/26)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **23.12.2022 KR 20220183596**

(71) Applicant: **LG Energy Solution, Ltd.
Seoul 07335 (KR)**

(72) Inventors:
• **PARK, Jinsoo**
  **Daejeon 34122 (KR)**
• **LEE, Hansol**
  **Daejeon 34122 (KR)**
• **JO, Jonghyun**
  **Daejeon 34122 (KR)**
• **JANG, Yeongik**
  **Daejeon 34122 (KR)**

(74) Representative: **Plasseraud IP
104 Rue de Richelieu
CS92104
75080 Paris Cedex 02 (FR)**

(54) **METHOD FOR DIAGNOSING INTERNAL SHORT CIRCUIT IN BATTERY AND BATTERY SYSTEM FOR PROVIDING METHOD**

(57) Provided are an internal short diagnosis method of a battery and a battery system providing the same, the battery system including: a battery including a plurality of battery cells; a cell monitoring integrated circuit (IC) collecting a first cell voltage of the battery cell that corresponds to a predetermined charge section in a charge cycle for charging the battery; and a main control circuit calculating a remaining charging time, which is a time required for a maximum value of the first cell voltage to reach a maximum value of a second cell voltage of a predetermined reference cell, calculating a remaining charge capacity, which is a difference value between a capacity of the battery cell and a capacity of the reference cell, based on the remaining charging time, and diagnosing a short circuit of the battery cell based on a result of comparing the remaining charge capacity with a predetermined capacity reference value.

FIG. 7

**Description**

**[Technical Field]**

CROSS-REFERENCE TO RELATED APPLICATION

This application claims priority to and the benefit of Korean Patent Application No. 10-2022-0183596 filed in the Korean Intellectual Property Office on December 23, 2022, the entire contents of which are incorporated herein by reference.

The present disclosure relates to an internal short diagnosis method of a battery and a battery system providing the same.

**[Background Art]**

A secondary battery may be a battery capable of being charged and discharged. The secondary battery may be used in a small and portable electronic device such as a mobile phone or a laptop personal computer (PC), or widely used as a power source for driving a motor of a power tool, an automobile, or the like. A positive electrode, a negative electrode, a separator, an electrolyte, and the like may be disposed in the secondary battery, and its case may be made of a metal plate or pouch.

Meanwhile, the secondary battery having high energy density may cause various safety problems. For example, the secondary battery may have an internal short circuit occurring as the separator loses its function due to deformation caused by external impact, a metallic foreign material included in a manufacturing process, and formation of lithium or copper dendrite by electrochemical reaction, or the like. When the short circuit occurs in the secondary battery, this phenomenon may cause a serious safety problem such as 'thermal runaway'.

Therefore, it is necessary to effectively detect the internal short circuit of the battery before the physical or thermal deformation of the battery is increased due to the internal short circuit of the battery.

**[Disclosure]**

**[Technical Problem]**

The present disclosure attempts to provide an internal short diagnosis method of a battery, which may diagnose the internal short circuit of a plurality of battery cells connected in series with each other with high precision, and a battery system providing the same.

**[Technical Solution]**

According to an embodiment, a battery system includes: a battery including a plurality of battery cells; a cell monitoring integrated circuit (IC) collecting a first cell voltage of the battery cell that corresponds to a predetermined charge section in a charge cycle for charging the battery; and a main control circuit calculating a remaining charging time, which is a time required for a maximum value of the first cell voltage to reach a maximum value of a second cell voltage of a predetermined reference cell, calculating a remaining charge capacity, which is a difference value between a capacity of the battery cell and a capacity of the reference cell, based on the remaining charging time, and diagnosing a short circuit of the battery cell based on a result of comparing the remaining charge capacity with a predetermined capacity reference value.

The main control circuit may calculate the remaining charge capacity based on the remaining charging time and a magnitude of a charging current of the battery.

The reference cell may be the battery cell having a largest maximum value among maximum values of the respective first cell voltages of the plurality of battery cells, or the battery cell having an average value of the respective first cell voltages of the plurality of battery cells.

The cell monitoring IC may collect the first cell voltage of the battery cell that corresponds to the charge section in a constant-current charge step of charging the battery with a predetermined magnitude of a charging current.

The plurality of battery cells may be connected in series with each other.

For each charge cycle, the main control circuit may extract a plurality of previous first charge cycles corresponding to a predetermined number of samples based on the charge cycle, calculate a moving average value, which is an average of the plurality of remaining charge capacities respectively corresponding to the plurality of first charge cycles, and calculate the capacity reference value by adding a predetermined error value to the moving average value.

For each charge cycle, the main control circuit may calculate a standard deviation based on the moving average value and the plurality of remaining charge capacities, and calculate the error value by multiplying the standard deviation by a predetermined multiple.

According to another embodiment, provided is an internal short diagnosis method of a battery, the method including: collecting a first cell voltage of a battery cell that corresponds to a predetermined charge section in a charge cycle for charging the battery including the plurality of battery cells; calculating a remaining charging time, which is a time required for a maximum value of the first cell voltage to reach a maximum value of a second cell voltage of a predetermined reference cell, and calculating a remaining charge capacity, which is a difference value between a capacity of the battery cell and a capacity of the reference cell, based on the remaining charging time; calculating a predetermined capacity reference value; and diagnosing a short circuit of the battery cell based on a result of comparing the remaining charge capacity with the predetermined capacity reference value.

In the calculating of the remaining charge capacity, the remaining charge capacity may be calculated based on the remaining charging time and a magnitude of a charging current of the battery.

The reference cell may be the battery cell having a largest maximum value among maximum values of the respective first cell voltages of the plurality of battery cells, or the battery cell having an average value of the respective first cell voltages of the plurality of battery cells.

In the collecting of the first cell voltage of the battery cell, the first cell voltage of the battery cell that corresponds to the charge section may be collected in a constant-current charge step of charging the battery with a predetermined magnitude of a charging current.

The plurality of battery cells may be connected in series with each other.

The calculating of the capacity reference value may include: extracting a plurality of previous first charge cycles corresponding to a predetermined number of samples based on the charge cycle, and calculating a moving average value, which is an average of the plurality of remaining charge capacities respectively corresponding to the plurality of first charge cycles; calculating a standard deviation based on the moving average value and the plurality of remaining charge capacities; and calculating a predetermined error value by multiplying the standard deviation by a predetermined multiple, and calculating the capacity reference value by adding the error value to the moving average value.

**[Advantageous Effects]**

The present disclosure may diagnose the internal short circuit of the battery cell based on its cell voltage detected in the charge cycle of the battery. Therefore, there is no need for a separate rest mode for the internal short circuit diagnosis after the charge cycle of the battery, so the present disclosure may not affect the operation schedule of the upper system (e.g., automobile).

The present disclosure may calculate a reference range based on the moving average (MA), which is the average of data adjacent to the current diagnosis time point, rather than the fixed reference range, and diagnose the internal short circuit based on the calculated reference range. Therefore, the present disclosure may increase the precision of the diagnosis by reducing the problem of misdiagnosing the aging or the like of the battery caused by its usage period as the internal short circuit.

**[Description of the Drawings]**

FIG. 1 is a block diagram explaining a battery system according to an embodiment.

FIG. 2 is an exemplary view showing a voltage change of a battery cell in the charge cycle and discharge cycle of a battery of FIG. 1.

FIG. 3 is an enlarged view of a partial section Sam_Z of the charge cycle or discharge cycle of FIG. 2.

FIG. 4 is an enlarged view of a sampling window SW in a constant-current charge step of FIG. 3, and is an exemplary view showing a method for deriving a remaining charging time $\Delta t$.

FIG. 5 is an exemplary view of a graph corresponding to the remaining charge capacity RCC, moving average MA, and capacity reference value Th-rcc of the battery cell according to an embodiment.

FIG. 6 is an exemplary view showing that an alarm message is generated in a section in FIG. 5 where the remaining charge capacity RCC has the capacity reference value Th-rcc or more.

FIG. 7 is a flowchart explaining an internal short diagnosis method of a battery according to another embodiment.

FIG. 8 is a flowchart showing in detail a step (S200) of calculating the remaining charge capacity RCC of FIG. 7.

FIG. 9 is a flowchart showing in detail a step (S300) of calculating the capacity reference value Th-rcc of FIG. 7.

**[Mode for Invention]**

Hereinafter, embodiments disclosed in the specification are described in detail with reference to the accompanying drawings, and the same or similar components are denoted by the same or similar reference numerals, and an overlapping description thereof is omitted. Terms "module" and/or "unit" for components described in the following description are used only to make the specification easily understood. Therefore, these terms do not have meanings or roles distinguished from each other in themselves. Further, in describing the embodiments of the present disclosure, in a case where it is decided that a detailed description of the known art related to the present disclosure may obscure the gist, the detailed description is omitted. Furthermore, it is to be understood that the accompanying drawings are provided only to allow the embodiments of the present disclosure to be easily understood, and the spirit of the present disclosure is not limited by the accompanying drawings and includes all the modifications, equivalents, and substitutions included in the spirit and scope of the present disclosure.

Terms including ordinal numbers such as "first," "second" and the like, may be used to describe various components. However, these components are not limited by these terms. The terms are used only to distinguish one component from another component.

It is to be understood that when referred to as being "connected to" or "coupled to" another element, one element may be connected directly to or coupled directly to another element, or connected to or coupled to another element having a third element interposed therebetween. On the other hand, it is to be understood that when referred to as being "connected directly to" or "coupled directly to" another element, one element may be connected to or coupled to another element without a third element interposed therebetween.

It is to be understood that terms "include," "have" and the like used in the present application specify the presence of features, numerals, steps, operations, components, parts or combinations thereof, mentioned in the specification, and do not preclude the presence or addition of one or more other features, numerals, steps, operations, components, parts or combinations thereof.

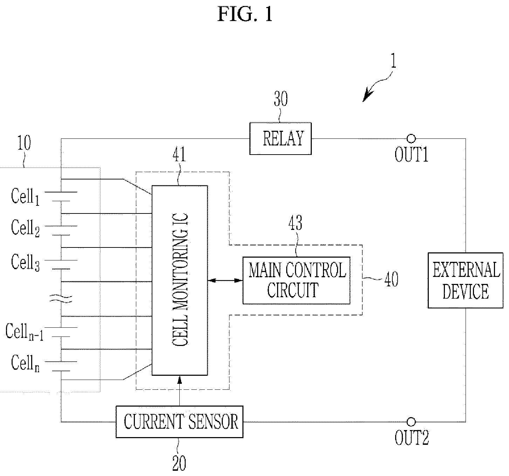

FIG. 1 is a block diagram explaining a battery system according to an embodiment.

Referring to FIG. 1, a battery system 1 may include a battery 10, a current sensor 20, a relay 30, and a battery management system (hereinafter referred to as BMS) 40.

In FIG. 1, the battery 10 is connected between two output terminals OUT1 and OUT2 of the battery system 1, and the relay 30 is connected between a positive electrode of the battery 10 and the first output terminal OUT1, and the current sensor 20 is connected between a negative electrode of the battery 10 and the second output terminal OUT2. The components and a connection relationship between the components, shown in FIG. 1, are examples, and the present disclosure is not limited thereto.

The battery 10 may include a plurality of battery cells Cell1 to Celln connected in series with each other. In some examples, the battery cell may be a rechargeable secondary battery. In addition, each of the plurality of battery cells Cell1 to Celln may be electrically connected to the BMS 40 through wiring. The BMS 40 may collect and analyze various information on the battery cells, including information on the plurality of battery cells Cell1 to Celln to control the charging, discharging, protection operation, or the like of the battery cell and control an operation of the relay 30.

The current sensor 20 may be connected in series to a current path between the battery 10 and an external device. The current sensor 20 may measure a battery current flowing through the battery 10, that is, a charging current or a discharging current, and transmit a measurement result to the BMS 40.

The relay 30 may control electrical connection between the battery system 1 and the external device. When the relay 30 is turned on, the battery system 1 and the external device may be electrically connected to each other to perform the charging or the discharging. In addition, when the relay 30 is turned off, the battery system 1 and the external devices may be electrically separated from each other. Here, the external device may be a charger in a charge cycle for charging the battery 10 by supplying power thereto, and may be a load in a discharge cycle for supplying power to the external device by the battery 10.

The BMS 40 may include a cell monitoring integrated circuit (IC) 41 and a main control circuit 43.

The cell monitoring IC 41 may be electrically connected to the positive and negative electrodes of each of the plurality of battery cells Cell1 to Celln, and measure a cell voltage of each of the plurality of battery cells Cell1 to Celln. In some examples, in the charge cycle for charging the battery 10 by power of the external device, the cell monitoring IC 41 may measure the cell voltage of each of the plurality of battery cells Cell1 to Celln corresponding to a predetermined sampling section W. A battery current value measured by the current sensor 20 may be transmitted to the cell monitoring IC 41. The cell monitoring IC 41 may transmit information on the measured cell voltage and the battery current to the main control circuit 43.

The main control circuit 43 may diagnose an internal short circuit occurring in each of the plurality of battery cells Cell1 to Celln for each charge cycle. For example, assume that the plurality of battery cells Cell1 to Celln are the battery cells all in a normal state. In this case, when the same amount of current flows through the plurality of battery cells Cell1 to Celln, each of the plurality of battery cells Cell1 to Celln may have the same charge capacity within a predetermined error range. Assume that a certain battery cell is in an abnormal state, for example, has an internal short circuit defect. In this case, even though the same amount of current flows through the plurality of battery cells Cell1 to Celln, a charge capacity of the battery cell having the internal short circuit defect may be smaller than that of the battery cell having no defect. That is, a charge capacity difference may occur between the plurality of battery cells Cell1 to Celln connected in series with each other based on whether the internal short circuit occurs in the battery cell.

In some examples, the main control circuit 43 may compare the respective charge capacities of the plurality of battery cells Cell1 to Celln for each charge cycle to diagnose the battery cell having the internal short circuit defect among the plurality of battery cells Cell1 to Celln.

Hereinafter, the description describes in detail a method of the main control circuit 43 diagnosing the battery cell having the internal short circuit defect based on a remaining charge capacity RCC of each of the plurality of battery cells Cell1 to Celln.

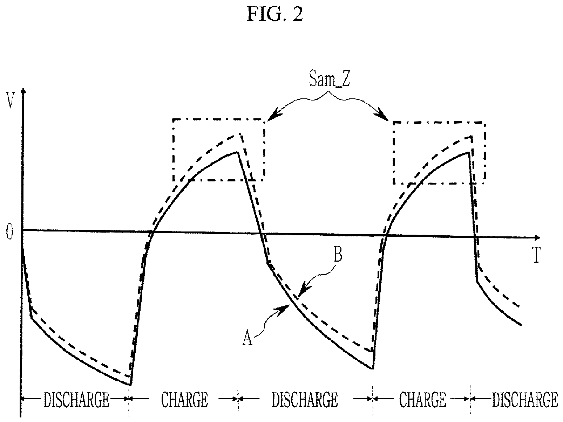

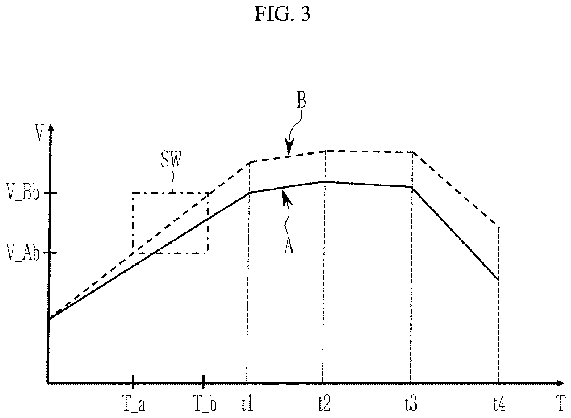

FIG. 2 is an exemplary view showing a voltage change of the battery cell in the charge cycle and discharge cycle of the battery of FIG. 1; and FIG. 3 is an enlarged view of a partial section Sam_Z of the charge cycle or discharge cycle of FIG. 2.

FIG. 2 is an exemplary view showing a voltage change of any one battery cell among the plurality of battery cells Cell1 to Celln in the charge cycle and discharge cycle of the battery.

Referring to FIG. 2, in the charge cycle of the battery 10, the cell voltage of each of the plurality of battery cells Cell1 to Celln included in the battery 10 may be gradually increased as the charging progresses. In addition, in the discharge cycle of the battery 10, the cell voltage of each of the plurality of battery cells Cell1 to Celln included in the battery 10 may be gradually decreased as the discharging progresses. Hereinafter, the charge cycle may refer to a period from when the charging of the battery 10 begins until the charging ends. In addition, the discharge cycle may refer to a period from when the discharging of the battery 10 begins until the discharging ends.

Referring to FIG. 3, which is the enlarged view of the section Sam_Z of the charge cycle or the discharge cycle, shown in FIG. 2, it may be assumed that the battery 10 is charged using a constant current (CC) charge method until a time point t1, the battery 10 is charged using a constant voltage (CV) charge method from the time point t1 to a time point t2, the battery 10 is in a rest mode in which no charging or discharging progresses from the time point t2 to a time point t3, and the battery 10 is discharged using the constant current (CC) discharge method after the time point t3.

The constant current (CC) charge method may be a method of charging the battery 10 while maintaining a magnitude of a charging current Ic to prevent overcurrent charging of the battery. When charging the battery 10 by using the constant current (CC) charge method, a magnitude of the cell voltage of each of the plurality of battery cells Cell1 to Celln connected in series with each other may be gradually increased as the charging progresses. The constant voltage (CV) charge method may be a method of charging the battery 10 while maintaining a magnitude of a charging voltage Vc to prevent the overcharging of the battery. When charging the battery 10 by using the constant voltage (CV) charge method, the cell voltage of each of the plurality of battery cells Cell1 to Celln may be maintained to be constant within a predetermined range even though the charging progresses.

The charge method shown in FIG. 3 is a constant current and constant voltage (CCCV) charge method in which a constant-current charge (CC) method and a constant-voltage charge (CV) method are used together in one charge cycle.

Referring to FIG. 2 or 3, a solid line A in a graph indicates the abnormal state, for example, the cell voltage change of the battery cell having the internal short circuit defect. In addition, a dotted line B in the graph indicates the cell voltage change of the battery cell in the normal state. It may be seen that even though the same current flows therethrough, the battery cell having the internal short circuit defect is not sufficiently charged than the battery cell in the normal state.

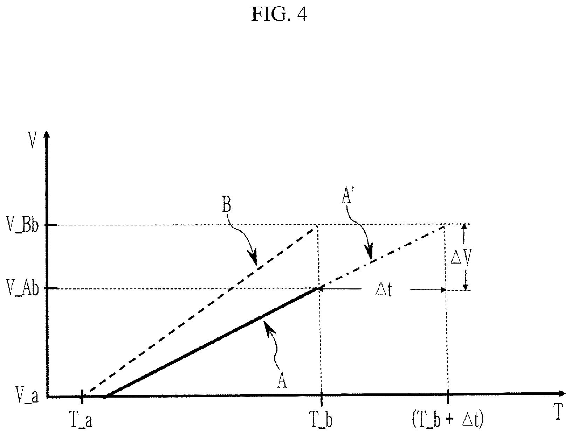

FIG. 4 is an enlarged view of a sampling window SW in a constant-current charge step of FIG. 3, and is an exemplary view showing a method for deriving a remaining charging time $\triangle t$.

The sampling window SW may refer to a section where the cell voltage of the battery cell is extracted in a constant-current charge (CC) step of the charge cycle. A size of the sampling window SW may be determined by an experiment and may depend on the specification or the like of the battery 10. For example, in FIG. 4, the size of the sampling window SW may correspond to a section from a start time point T_a to an end time point T_b.

Referring to FIGS. 3 and 4, a predetermined battery cell may have the smallest cell voltage corresponding to the start time point T_a and the largest cell voltage V_b corresponding to the end time point T_b among the cell voltages extracted from the sampling window SW. Hereinafter, the cell voltage V_b corresponding to the end time point T_b may be defined as an end voltage.

A first cell voltage V_A may indicate the cell voltage of the battery cell which is a target where the internal short circuit is determined to occur. A second cell voltage V_B may indicate a cell voltage of a reference cell serving as a diagnosis reference. For example, a first end voltage may be the first cell voltage of the battery cell that corresponds to the end time point T_b. A second end voltage V_Bb may be the second cell voltage of the reference cell that corresponds to the end time point T_b.

In some examples, the main control circuit 43 may output the remaining charging time $\triangle t$, which is an additional time required for a value of the first end voltage V_Ab of the battery cell to reach the second end voltage V_Bb of the reference cell.

The reference cell may be defined as the battery cell serving as a reference for diagnosing the internal short circuit defect. In FIG. 4, a first voltage graph A for any one of the plurality of battery cells Cell1 to Celln, which is the target where the internal short circuit is determined to occur, may be indicated as the solid line. In addition, a second voltage graph B for the reference cell may be indicated as the dotted line. In some examples, the battery cell having the maximum first end voltage among the plurality of battery cells Cell1 to Celln included in the battery 10 may be determined as the reference cell. However, the reference cell is not limited hereto, and may be determined based on various references.

Table 1 below shows an example of the first cell voltage of each of the first to third battery cells Cell1, Cell2, and Cell3 that is measured for each predetermined period in the sampling window SW when assuming that the three battery cells Cell1, Cell2, and Cell3 are included in the battery 10.

[Table 1]

| Cell voltage | Start time point T_a | ... | End time point T_b -2 | End time point T_b -1 | End time point T_b |
|---|---|---|---|---|---|
| First battery cell | 3.1 | ... | 3.7 | 3.8 | 4.1 |
| Second battery cell | 3.1 | ... | 3.7 | 3.85 | 3.9 |
| Third battery cell | 3.1 | ... | 3.7 | 3.75 | 3.95 |

Referring to Table 1 above, the first end voltage V_Ab of the first battery cell may be 4.1 V, the first end voltage V_Ab of the second battery cell may be 3.9 V, and the first end voltage V_Ab of the third battery cell may be 3.95 V. In some examples, the first battery cell Cell1 having the maximum first end voltage V_Ab of 4.1 V among the first to third battery cells Cell1, Cell2, and Cell3 included in the battery 10 may be determined as the reference cell. Here, it is possible to ignore a magnitude of the first cell voltage measured in the cycle before the end time point T_b.

In other examples, a voltage graph in the sampling window SW may be calculated based on an average value of the respective first cell voltages of the plurality of battery cells Cell1 to Celln, and a virtual battery cell corresponding to the calculated voltage graph may be determined as the reference cell. For example, the second cell voltage of the reference cell as shown in Table 2 below may be calculated based on the average value of the respective first cell voltages of the first to third battery cells Cell1, Cell2, and Cell3 disclosed in Table 1 above.

[Table 2]

| Cell voltage | Start time point T_a | ... | End time point T_b -2 | End time point T_b -1 | End time point T_b |
|---|---|---|---|---|---|
| First battery cell | 3.1 | ... | 3.7 | 3.8 | 4.1 |
| Second battery cell | 3.1 | ... | 3.7 | 3.85 | 3.9 |
| Third battery cell | 3.1 | ... | 3.7 | 3.75 | 3.95 |
| Reference cell | 3.1 | ... | 3.7 =(3.7+3.7+3.7)/3 | 3.8 =(3.8+3.85 +3.75)/3 | 3.93 =(4.1 +3.9+3.95)/3 |

Referring to Table 2 above, the second end voltage V_Bb of the reference cell may be calculated as the average of the first end voltage V_Ab of each of the first to third battery cells Cell1, Cell2, and Cell3. Referring to Table 1 and FIG. 4, the second end voltage V_Bb in the second voltage graph B for the reference cell may be 3.93 V.

In still other examples, except for the battery cell having the first end voltage V_Ab more than a standard deviation multiplied by a predetermined multiple among the respective first end voltages V_Ab of the plurality of battery cells Cell1 to Celln in the sampling window SW, the voltage graph may be calculated based on the average value of the respective first cell voltages of the remaining of the plurality of battery cells Cell1 to Celln, and the virtual battery cell corresponding to the calculated voltage graph may be determined as the reference cell.

For example, referring to Table 1, the average value of the respective first end voltages V_Ab of the first to third battery cells Cell1, Cell2, and Cell3 may be 3.93 V. Here, assume that the standard deviation is 0.05 and a predetermined multiple $\alpha$ is 1. In this case, the first end voltage V_Ab (4.1V) of the first battery cell may be more than a result of adding the average value to a value acquired by multiplying the standard deviation by the predetermined multiple (3.93 + 0.05 = 3.98), which may thus be excluded from reference cell calculation. As shown in Table 3 below, the voltage graph for a virtual reference cell may thus be calculated based on the average value of the respective first cell voltages of the second battery cell and the third battery cell.

[Table 3]

| Cell voltage | Start time point T_a | ... | End time point T_b -2 | End time point T_b -1 | End time point T_b |
|---|---|---|---|---|---|
| Second battery cell | 3.1 | ... | 3.7 | 3.85 | 3.9 |
| Third battery cell | 3.1 | ... | 3.7 | 3.75 | 3.95 |
| Reference cell | 3.1 | ... | 3.7 =(3.7+3.7)/2 | 3.8 =(3.85+3.75)/2 | 3.925 =(3.9+ 3.95)/2 |

Referring to FIG. 4, the main control circuit 43 may calculate the remaining charging time $\triangle t$ based on inclination of the first voltage graph A of the battery cell in the sampling window SW and a difference value $\triangle V = V\_Bb - V\_Ab$ between the first end voltage and the second end voltage. However, the present disclosure is not limited hereto, and the main control circuit 43 may calculate the remaining charging time $\triangle t$ by using various well known arithmetic methods.

First, the main control circuit 43 may generate a virtual voltage graph A' by extending the first voltage graph A to the second end voltage V\_Bb, based on the inclination of the first voltage graph A. Here, the main control circuit 43 may extend the graph by using various well known algorithms. In FIG. 4, the virtual voltage graph A' is indicated by alternate long and short dash lines.

Next, the main control circuit 43 may calculate a virtual end time point $T\_b + \triangle t$, which is a horizontal axis coordinate matching the second end voltage V\_Bb of the virtual voltage graph A'. The main control circuit 43 may calculate the remaining charging time $\triangle t$ based on a difference value between the end time point T\_b of the sampling window SW and the virtual end time point $T\_b + \triangle t$.

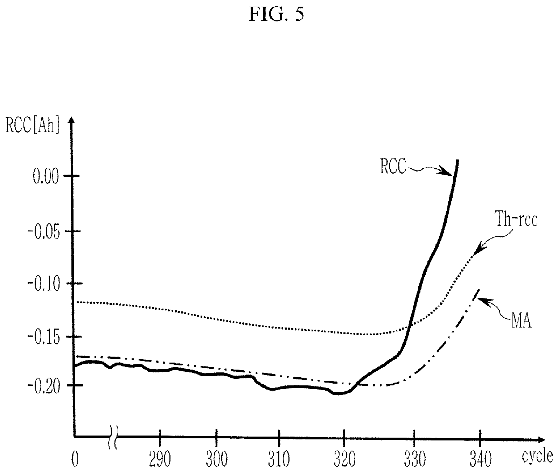

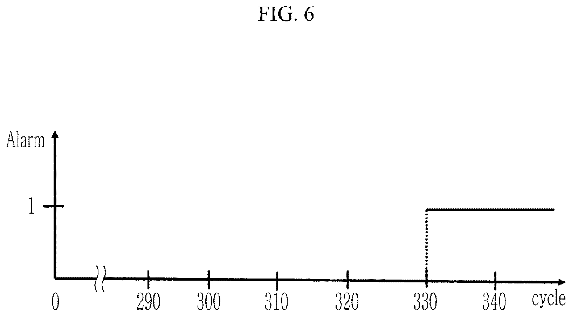

FIG. 5 is an exemplary view of a graph corresponding to the remaining charge capacity RCC, moving average MA, and capacity reference value Th-rcc of the battery cell according to an embodiment; and FIG. 6 is an exemplary view showing that an alarm message is generated in the section in FIG. 5 where the remaining charge capacity RCC has the capacity reference value Th-rcc or more.

The description hereinafter focuses on one battery cell among the plurality of battery cells Cell1 to Celln. However, a method described below may be equally applied to each of the plurality of battery cells Cell1 to Celln.

Referring to FIG. 3, according to an embodiment, the same magnitude of the charging current Ic may flow through each of the plurality of battery cells Cell1 to Celln connected in series with each other. As described above, when the same amount of current flows through the plurality of battery cells Cell1 to Celln, each of the plurality of battery cells Cell1 to Celln may have the same charge capacity within the predetermined error range. If there is the battery cell having the internal short circuit defect, the charge capacity of the corresponding battery cell may be significantly different from that of another battery cell (for example, the reference cell). In some examples, the main control circuit 43 may diagnose the internal short circuit defect of the battery cell based on the difference value between the charge capacities.

The remaining charge capacity RCC may correspond to the difference value between the charge capacity of the reference cell and that of the battery cell under the same charging condition. There may be a high possibility that the short circuit defect occurs in the battery cell as the difference value is larger.

The main control circuit 43 may calculate the remaining charge capacity RCC based on the remaining charging time $\triangle t$ and the charging current Ic. In detail, the main control circuit 43 may calculate the remaining charge capacity RCC of the battery cell based on Equation 1 below:

$$RCC = Ic \times \triangle t \times \frac{1h}{3600s} [Ah]$$

\- Equation 1

Here, 'Ic' indicates the charging current supplied to the battery 10 in the constant-current charge (CC) step of the charge cycle, and $\triangle t$ indicates the remaining charging time and its unit may be a second S. In addition, a unit of the remaining charge capacity RCC may be 'Ah', which is a capacity unit of the battery 10.

For each charge cycle, the main control circuit 43 may calculate the remaining charge capacity RCC of the battery cell, and compare the calculated remaining charge capacity RCC with the capacity reference value Th-rcc.

Referring to FIG. 5, from a charge cycle corresponding to 330 times, the remaining charge capacity RCC of the battery cell may have the capacity reference value Th-rcc or more. When the remaining charge capacity RCC has the capacity reference value Th-rcc or more, the main control circuit 43 may generate the alarm message. Referring to FIGS. 5 and 6, the main control circuit 43 may continuously generate the alarm message starting from the 330th charge cycle.

The capacity reference value Th-rcc may be a reference value used to diagnose the internal short circuit defect. As described above, the corresponding battery cell may not be in the normal state when the remaining charge capacity RCC, which corresponds to the difference value between the charge capacity of the reference cell and that of the battery cell, is increased to have a predetermined reference value or more. The reference value in this case may be the capacity reference value Th-rcc.

In some examples, for each charge cycle, the main control circuit 43 may calculate the moving average MA, the capacity reference value Th-rcc which is greater by a predetermined value than the moving average value M, and the remaining charge capacity RCC corresponding to a current charge cycle N.

First, the main control circuit 43 may determine a sample group by extracting the plurality of charge cycles included in a predetermined number of samples SN when counting the charge cycle in a direction toward a previous charge cycle based on the current charge cycle N. Here, the number of samples SN may be the number of plurality of charge cycles included in the sample group, and may be determined as the optimal number based on an experiment, or the like. The sample group may be a subgroup of each of the plurality of previous charge cycles, which are parent groups, and may be a group for calculating the moving average value MA described below.

Table 4 below shows an example of the remaining charge capacity RCC, the moving average value MA, and the capacity reference value Th-rcc, calculated for each of the plurality of charge cycles. The number of samples SN may be assumed to be 4.

[Table 4]

|  | 1 | ... | N-3 | N-2 | N-1 | N |
|---|---|---|---|---|---|---|
| Remaining charge capacity RCC | 0.5 |  | 0.5 | 0.45 | 0.5 | 0.5 |
| Moving average MA | - |  | 0.4870 | 0.485 | 0.4875 | MA_n |
| Standard deviation Std | - |  | 0.0214 | 0.0222 | 0.0225 | Std_n |
| Capacity reference value Th-rcc | - |  | 0.5750 | 0.5745 | 0.5750 | Th-rcc_n |

In some examples, the main control circuit 43 may determine the sample group by extracting an Nth charge cycle, an N-1th charge cycle, an N-2th charge cycle, and an N-3th charge cycle, corresponding to the numbers of samples SN of four, when counting the charge cycle in the direction toward the previous charge cycle based on the current charge cycle N.

In other examples, the main control circuit 43 may determine the sample group by extracting the N-1th charge cycle, the N-2th charge cycle, the N-3th charge cycle, and an N-4th charge cycle, corresponding to the four numbers of samples SN, when counting the charge cycle in the direction of the previous charge cycle based on the current charge cycle N. That is, the current charge cycle N may be included in the sample group, is not limited thereto, and may be excluded therefrom. Hereinafter, the description is provided on an assumption that the current charge cycle N is included in the sample group.

Next, the main control circuit 43 may determine an Nth capacity reference value Th-rcc_n, which is a reference value for diagnosing the battery defect occurring in the Nth charge cycle based on the remaining charge capacity RCC calculated from each of the plurality of charge cycles N-3th, N-2th, N-1th, and Nth, belonging to the sample group.

Table 5 below shows an example of a calculation method for an Nth moving average value MA_n, an Nth standard deviation Std_n, and the Nth capacity reference value Th-rcc_n, calculated in the Nth charge cycle. In Table 5 below, the predetermined multiple $\alpha$ is assumed to be 4, which is the natural number.

[Table 5]

|  | N-3 | N-2 | N-1 | N |
|---|---|---|---|---|
| Remaining charge capacity RCC | 0.5 | 0.45 | 0.5 | 0.5 |
| Moving average MA n | $0.4875 = (0.5+0.45+0.5+0.5)/4$ | | | |
| \|RCC- MA_n\| | 0.0125 | 0.0375 | 0.0125 | 0.0125 |
| $(RCC- MA_n)^2$ | 0.00015625 | 0.00140625 | 0.00015625 | 0.00015625 |
| Standard deviation Std n | $\sqrt{0.00046875} = 0.02165063510$ | | | |
| Capacity reference value Th-rcc n | $MA\text{-}n + (Th\text{-}rcc\_n) \times a \fallingdotseq 0.5741$ | | | |

By using the methods described in Tables 4 and 5 above, the main control circuit 43 may calculate the remaining charge capacity RCC and capacity reference value Th-rcc for each of the plurality of battery cells Cell1 to Celln for each charge cycle. In addition, the main control circuit 43 may calculate the moving average value MA and the standard deviation Std to calculate the capacity reference value Th-rcc. For example, the graph shown in FIG. 5 may be derived assuming that the charge cycle progresses approximately 338 times.

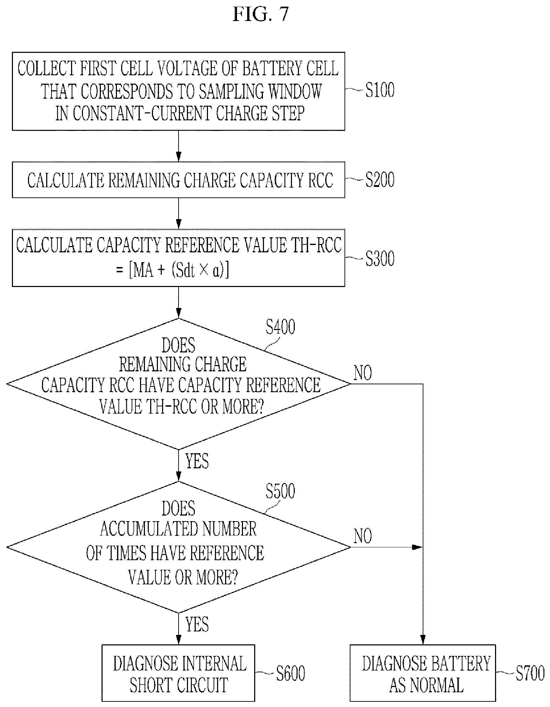

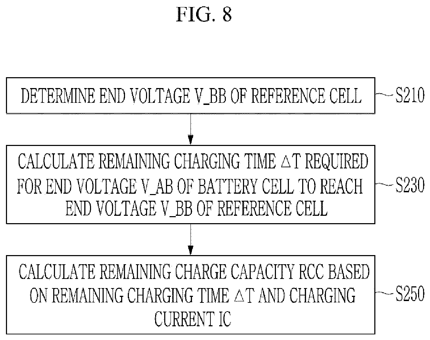

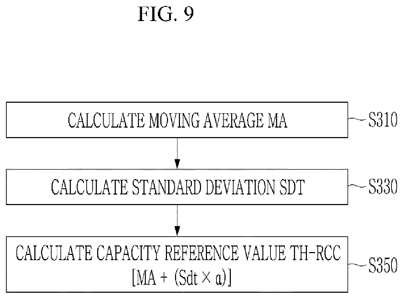

FIG. 7 is a flowchart explaining an internal short diagnosis method of a battery according to another embodiment; FIG. 8 is a flowchart showing in detail a step (S200) of calculating the remaining charge capacity RCC of FIG. 7; and FIG. 9 is a flowchart showing in detail a step (S300) of calculating the capacity reference value Th-rcc of FIG. 7.

Hereinafter, the internal short diagnosis method of a battery and the battery system providing the same are described in detail with reference to FIGS. 1 through 9. Hereinafter, the description describes an internal short circuit defect diagnosis method of any one battery cell among the plurality of battery cells Cell1 to Celln. However, a method described below may be equally applied to each of the plurality of battery cells Cell1 to Celln.

Referring to FIG. 7, the main control circuit 43 may first collect the first cell voltage of the battery cell that corresponds to the sampling window, which is a predetermined charge section, in the charge cycle for charging the battery 10 by power of the external device (S100).

The sampling window may be determined to have a predetermined size in the constant-current charge step of charging the battery 10 with a predetermined magnitude of the charging current. Referring to FIG. 3, the size of the sampling window may be defined as the charge section from the start time point T_a to the end time point T_b. The cell monitoring IC 41 may transmit, to the main control circuit 43, the first cell voltage of the battery cell that is measured in the sampling window for each predetermined cycle or in real time.

Next, the main control circuit 43 may calculate the remaining charge capacity RCC which is the difference value between the charge capacity of the reference cell and that of the battery cell in the sampling window (S200).

The remaining charge capacity RCC may correspond to the charge capacity necessary to be filled by the battery cell in order to correspond to the maximum charge capacity of the reference cell in the sampling window. That is, the remaining charge capacity RCC may be an insufficient amount of the charge capacity of the battery cell compared to the charge capacity of the reference cell.

When the battery 10 is charged by the constant-current charge (CC) method, the same size of the charging current Ic may be supplied to each of the plurality of battery cells Cell1 to Celln connected in series with each other. Therefore, the charge capacity of each of the plurality of battery cells Cell1 to Celln may be the same within the predetermined error range. If there is the battery cell having the internal short circuit defect among the plurality of battery cells Cell1 to Celln, the charge capacity of the corresponding battery cell may differ from that of another battery cell. Here, another battery cell may be used as the reference cell for comparison.

Referring to FIG. 8, in step S200, the main control circuit 43 may determine the second end voltage V_Bb of the reference cell, which is a reference battery cell for the internal short circuit defect diagnosis (S210).

In some examples, the battery cell having the maximum first end voltage among the plurality of battery cells Cell1 to Celln included in the battery 10 may be determined as the reference cell. For example, referring to Table 1, the first battery cell Cell1 having the maximum first end voltage V_Ab among the first to third battery cells Cell1, Cell2, and Cell3 included in the battery 10 may be determined as the reference cell.

In other examples, the main control circuit 43 may calculate a virtual voltage graph based on the average value of the respective first cell voltages of the plurality of battery cells Cell1 to Celln in the sampling window SW, and determine the virtual battery cell corresponding to the calculated virtual voltage graph as the reference cell. Its specific example may refer to Table 2 described above.

In still other examples, except for the battery cell having the first end voltage V_Ab more than the standard deviation multiplied by the predetermined multiple among the respective first end voltages V_Ab of the plurality of battery cells Cell1 to Celln in the sampling window SW, the main control circuit 43 may calculate the voltage graph based on the average value of the respective first cell voltages of the remaining of the plurality of battery cells Cell1 to Celln, and determine the virtual battery cell corresponding to the calculated voltage graph as the reference cell. Its specific example may refer to Table 3 described above.

The main control circuit 43 may determine the reference cell based on the various examples described above. In addition, referring to FIG. 4, the main control circuit 43 may determine the cell voltage V_b of a reference cell B that corresponds to the end time point T_b of the sampling window SW as the second end voltage V_Bb.

In step S200, the main control circuit 43 may output the remaining charging time △t, which is an additional time required for the value of the first end voltage V_Ab of the battery cell to reach the value of the second end voltage V_Bb of the reference cell (S230).

Referring to FIG. 4, the main control circuit 43 may calculate the remaining charging time △t based on the inclination of the first voltage graph A of the battery cell in the sampling window SW and the difference value △V = V_Bb - V_Ab between the respective end voltages of the battery cell and the reference cell.

First, the main control circuit 43 may generate the virtual voltage graph A' by extending the first voltage graph A to the second end voltage V_Bb, based on the inclination of the first voltage graph A. Here, the main control circuit 43 may extend the graph by using the various well known algorithms. In FIG. 4, the virtual voltage graph A' is indicated by the alternate long and short dash lines.

Next, the main control circuit 43 may calculate the virtual end time point T_b + △t, which is the horizontal axis coordinate matching the second end voltage V_Bb of the virtual voltage graph A'. The main control circuit 43 may calculate the remaining charging time $\triangle$t based on the difference value between the end time point T_b of the sampling window SW and the virtual end time point T_b + $\triangle$t.

In step S200, the main control circuit 43 may calculate the remaining charge capacity RCC based on the remaining charging time $\triangle$t and the magnitude of the charging current Ic of the battery (S250).

The magnitude of the charging current Ic may correspond to a magnitude of the charging current supplied to the battery 10 in the sampling window SW. In some examples, the main control circuit 43 may calculate the remaining charge capacity RCC of the battery cell based on Equation 1.

Next, the main control circuit 43 may calculate the capacity reference value Th-rcc (S300).

The capacity reference value Th-rcc may be the reference value used to diagnose the internal short circuit defect. In some examples, the main control circuit 43 may calculate the remaining charge capacity RCC and capacity reference value Th-rcc of the battery cell for each charge cycle.

In step S300, the main control circuit 43 may configure the sample group by extracting the previous charge cycle corresponding to the predetermined number of samples based on the current charge cycle, and calculate the moving average value MA by averaging the remaining charge capacities RCC corresponding to the respective charge cycles belonging to the sample group (S310).

The main control circuit 43 may determine the sample population by extracting the plurality of charge cycles included in the predetermined number of samples SN when counting the charge cycle in the direction toward the previous charge cycle based on the current charge cycle N. Here, the number of samples SN may be the number of plurality of charge cycles included in the sample group, and may be determined as the optimal number based on the experiment, or the like. The sample group may be the subgroup of each of the plurality of previous charge cycles, which are the parent groups, and may be the group for calculating the moving average value MA.

In step S300, the main control circuit 43 may calculate the standard deviation Sdt based on the remaining charge capacity RCC of each extracted previous charge cycle and the calculated moving average value MA (S330).

In some examples, the sample group for calculating the moving average value MA and the sample group for calculating the standard deviation Sdt may be the same as each other. In other examples, the sample group for calculating the moving average value MA and the sample group for calculating the standard deviation Sdt may be the different from each other.

For example, assume that a first sample group for calculating the moving average value MA has the number of samples SN of 3. The main control circuit 43 may then calculate the moving average value MA based on the remaining charge capacity RCC corresponding to each of an N-3th charge cycle N-3, an N-2th charge cycle N-2, and an N-1th charge cycle N-1. In addition, a second sample group for calculating the standard deviation Sdt may be assumed to include the charge cycles from a first charge cycle to the current charge cycle N. The main control circuit 43 may then calculate the standard deviation Sdt based on the remaining charge capacity RCC corresponding to each of the first to the Nth (i.e., first, second, ... , N-1th, and Nth) charge cycles, and the moving average value MA calculated based on the first sample group. However, the sample group is not limited thereto, and may be determined to include various numbers of samples.

In step S300, the main control circuit 43 may calculate the capacity reference value Th-rcc by adding an error value, which is acquired by multiplying the standard deviation Sdt by the predetermined multiple $\alpha$, to the moving average value MA (S350).

The predetermined multiple $\alpha$ may be experimentally calculated based on various situations such as the specification and usage period of the battery 10. For example, the predetermined multiple $\alpha$ may be a predetermined integer.

Next, the main control circuit 43 may determine whether the remaining charge capacity RCC has the capacity reference value Th-rcc or more (S400).

When the remaining charge capacity RCC has the capacity reference value Th-rcc or more, the main control circuit 43 may generate the alarm message indicating the corresponding content. The main control circuit 43 may transmit the generated alarm message to an upper system.

Next, when the remaining charge capacity RCC has the capacity reference value Th-rcc or more as a determination result (YES in S400), the main control circuit 43 may determine whether the accumulated number of charge cycles, in which the remaining charge capacity RCC has the capacity reference value Th-rcc or more, has the reference value or more (S500).

Next, when the accumulated number has the reference value or more (YES in S500), the main control circuit 43 may diagnose the internal short circuit of the battery cell (S600).

Next, when the remaining charge capacity RCC has a value less than the capacity reference value Th-rcc (NO in S400) or the accumulated number has a value less than the reference value as the determination result (NO in S500), the main control circuit 43 may diagnose that no internal short circuit defect occurs in the battery cell (S700).

Referring to FIG. 6, for the first time in the 330th charge cycle, an event occurs where the remaining charge capacity RCC has the capacity reference value Th-rcc or more, and this event also occurs in the next charge cycle. In some examples, when the reference value is 1, the main control circuit 43 may generate the alarm message, and diagnose the internal short circuit of the battery cell at the 330th charge cycle. In other examples, when the reference value is 10, the main control circuit 43 may continuously generate the alarm message starting from the 330th charge cycle, and diagnose the internal short circuit of the battery cell at the 340th charge cycle.

Although the embodiments of the present disclosure have been described in detail hereinabove, the scope of the present disclosure is not limited thereto. Various modifications and improvements made by those skilled in the art to which the present disclosure pertains also belong to the scope of the present disclosure.

**Claims**

1.  A battery system comprising:

    a battery including a plurality of battery cells;
    a cell monitoring integrated circuit (IC) collecting a first cell voltage of the battery cell that corresponds to a predetermined charge section in a charge cycle for charging the battery; and
    a main control circuit calculating a remaining charging time, which is a time required for a maximum value of the first cell voltage to reach a maximum value of a second cell voltage of a predetermined reference cell, calculating a remaining charge capacity, which is a difference value between a capacity of the battery cell and a capacity of the reference cell, based on the remaining charging time, and diagnosing a short circuit of the battery cell based on a result of comparing the remaining charge capacity with a predetermined capacity reference value.

2.  The system of claim 1, wherein

    the main control circuit calculates
    the remaining charge capacity based on the remaining charging time and a magnitude of a charging current of the battery.

3.  The system of claim 1, wherein

    the reference cell is
    the battery cell having a largest maximum value among maximum values of the respective first cell voltages of the plurality of battery cells, or the battery cell having an average value of the respective first cell voltages of the plurality of battery cells.

4.  The system of claim 1, wherein

    the cell monitoring IC collects
    the first cell voltage of the battery cell that corresponds to the charge section in a constant-current charge step of charging the battery with a predetermined magnitude of a charging current.

5.  The system of claim 1, wherein

    the plurality of battery cells are
    connected in series with each other.

6.  The system of claim 1, wherein

    for each charge cycle, the main control circuit extracts
    a plurality of previous first charge cycles corresponding to a predetermined number of samples based on the charge cycle, calculates a moving average value, which is an average of the plurality of remaining charge capacities respectively corresponding to the plurality of first charge cycles, and calculates the capacity reference value by adding a predetermined error value to the moving average value.

7.  The system of claim 6, wherein

    for each charge cycle, the main control circuit calculates
    a standard deviation based on the moving average value and the plurality of remaining charge capacities, and calculates the error value by multiplying the standard deviation by a predetermined multiple.

8. An internal short diagnosis method of a battery, the method comprising:

collecting a first cell voltage of a battery cell that corresponds to a predetermined charge section in a charge cycle for charging the battery including the plurality of battery cells;
calculating a remaining charging time, which is a time required for a maximum value of the first cell voltage to reach a maximum value of a second cell voltage of a predetermined reference cell, and calculating a remaining charge capacity, which is a difference value between a capacity of the battery cell and a capacity of the reference cell, based on the remaining charging time;
calculating a predetermined capacity reference value; and
diagnosing a short circuit of the battery cell based on a result of comparing the remaining charge capacity with the predetermined capacity reference value.

9. The method of claim 8, wherein

in the calculating of the remaining charge capacity,
the remaining charge capacity is calculated based on the remaining charging time and a magnitude of a charging current of the battery.

10. The method of claim 8, wherein

the reference cell is
the battery cell having a largest maximum value among maximum values of the respective first cell voltages of the plurality of battery cells, or the battery cell having an average value of the respective first cell voltages of the plurality of battery cells.

11. The method of claim 8, wherein

in the collecting of the first cell voltage of the battery cell,
the first cell voltage of the battery cell that corresponds to the charge section is collected in a constant-current charge step of charging the battery with a predetermined magnitude of a charging current.

12. The method of claim 8, wherein

the plurality of battery cells are
connected in series with each other.

13. The method of claim 8, wherein
the calculating of the predetermined capacity reference value includes:

extracting a plurality of previous first charge cycles corresponding to a predetermined number of samples based on the charge cycle, and calculating a moving average value, which is an average of the plurality of remaining charge capacities respectively corresponding to the plurality of first charge cycles;
calculating a standard deviation based on the moving average value and the plurality of remaining charge capacities; and
calculating a predetermined error value by multiplying the standard deviation by a predetermined multiple, and calculating the predetermined capacity reference value by adding the error value to the moving average value.

FIG. 1

FIG. 2

## FIG. 3

FIG. 4

FIG. 5

FIG. 6

## FIG. 7

COLLECT FIRST CELL VOLTAGE OF BATTERY CELL THAT CORRESPONDS TO SAMPLING WINDOW IN CONSTANT-CURRENT CHARGE STEP ～S100

↓

CALCULATE REMAINING CHARGE CAPACITY RCC ～S200

↓

CALCULATE CAPACITY REFERENCE VALUE TH-RCC = [MA + (Sdt × α)] ～S300

↓

S400
DOES REMAINING CHARGE CAPACITY RCC HAVE CAPACITY REFERENCE VALUE TH-RCC OR MORE? —NO

YES ↓

S500
DOES ACCUMULATED NUMBER OF TIMES HAVE REFERENCE VALUE OR MORE? —NO

YES ↓

DIAGNOSE INTERNAL SHORT CIRCUIT ～S600

DIAGNOSE BATTERY AS NORMAL ～S700

FIG. 8

| DETERMINE END VOLTAGE V_BB OF REFERENCE CELL | ~S210 |

| CALCULATE REMAINING CHARGING TIME $\triangle$T REQUIRED FOR END VOLTAGE V_AB OF BATTERY CELL TO REACH END VOLTAGE V_BB OF REFERENCE CELL | ~S230 |

| CALCULATE REMAINING CHARGE CAPACITY RCC BASED ON REMAINING CHARGING TIME $\triangle$T AND CHARGING CURRENT IC | ~S250 |

FIG. 9

| | |
|---|---|
| CALCULATE MOVING AVERAGE MA | ~S310 |

| | |
|---|---|
| CALCULATE STANDARD DEVIATION SDT | ~S330 |

| | |
|---|---|
| CALCULATE CAPACITY REFERENCE VALUE TH-RCC<br>[MA + (Sdt × α)] | ~S350 |

## INTERNATIONAL SEARCH REPORT

| International application No. |
| --- |
| **PCT/KR2023/014168** |

**A. CLASSIFICATION OF SUBJECT MATTER**

**G01R 31/52**(2020.01)i; **G01R 31/392**(2019.01)i; **G01R 31/396**(2019.01)i; **G01R 31/385**(2019.01)i; **G01R 31/3842**(2019.01)i; **G01R 19/30**(2006.01)i

According to International Patent Classification (IPC) or to both national classification and IPC

**B. FIELDS SEARCHED**

Minimum documentation searched (classification system followed by classification symbols)

G01R 31/52(2020.01); B60L 11/18(2006.01); G01R 31/36(2006.01); G01R 31/3842(2019.01); G01R 31/387(2019.01); G01R 31/396(2019.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 전압(voltage), 잔여 충전 시간(remaining charging time), 잔여 용량 (remaining capacity)

**C. DOCUMENTS CONSIDERED TO BE RELEVANT**

| Category* | Citation of document, with indication, where appropriate, of the relevant passages | Relevant to claim No. |
| --- | --- | --- |
| A | US 2019-0219640 A1 (HUAWEI TECHNOLOGIES CO., LTD.) 18 July 2019 (2019-07-18)<br>See paragraphs [0131]-[0151] and figure 2. | 1-13 |
| A | CN 112858931 A (CHONGQING HUANNENG ELECTRIC VEHICLE TECHNOLOGY CO., LTD.) 28 May 2021 (2021-05-28)<br>See paragraphs [0055]-[0077] and figures 1-3. | 1-13 |
| A | CN 114035074 A (UNIVERSITY OF SHANGHAI FOR SCIENCE & TECHNOLOGY) 11 February 2022 (2022-02-11)<br>See claim 1. | 1-13 |
| A | KR 10-2017-0074132 A (YANG, Seong-Mo) 29 June 2017 (2017-06-29)<br>See claims 1-3 and figures 1-2a. | 1-13 |
| A | KR 10-2020-0039215 A (LG CHEM, LTD.) 16 April 2020 (2020-04-16)<br>See claims 1-2 and figure 5. | 1-13 |

☐ Further documents are listed in the continuation of Box C.      ☑ See patent family annex.

| | |
| --- | --- |
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **02 January 2024** | **02 January 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

| International application No. |
| --- |
| **PCT/KR2023/014168** |

| Patent document cited in search report | | | Publication date (day/month/year) | Patent family member(s) | | | Publication date (day/month/year) |
| --- | --- | --- | --- | --- | --- | --- | --- |
| US | 2019-0219640 | A1 | 18 July 2019 | CN | 107870301 | A | 03 April 2018 |
| | | | | CN | 107870301 | B | 04 September 2020 |
| | | | | DK | 3832328 | T3 | 28 March 2022 |
| | | | | EP | 3508867 | A1 | 10 July 2019 |
| | | | | EP | 3508867 | A4 | 04 September 2019 |
| | | | | EP | 3508867 | B1 | 25 November 2020 |
| | | | | EP | 3832328 | A1 | 09 June 2021 |
| | | | | EP | 3832328 | B1 | 02 March 2022 |
| | | | | US | 11215679 | B2 | 04 January 2022 |
| | | | | WO | 2018-059074 | A1 | 05 April 2018 |
| CN | 112858931 | A | 28 May 2021 | None | | | |
| CN | 114035074 | A | 11 February 2022 | CN | 114035074 | B | 29 August 2023 |
| KR | 10-2017-0074132 | A | 29 June 2017 | None | | | |
| KR | 10-2020-0039215 | A | 16 April 2020 | CN | 112888954 | A | 01 June 2021 |
| | | | | EP | 3859363 | A1 | 04 August 2021 |
| | | | | EP | 3859363 | A4 | 08 December 2021 |
| | | | | KR | 10-2391533 | B1 | 28 April 2022 |
| | | | | US | 2022-0043068 | A1 | 10 February 2022 |
| | | | | WO | 2020-071848 | A1 | 09 April 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220183596